Europäisches Patentamt

(19) European Patent Office

Office européen des brevets

(11) Publication number : **0 448 227 A1**

(12) **EUROPEAN PATENT APPLICATION**

(21) Application number : **91301327.2**

(22) Date of filing : **20.02.91**

(51) Int. Cl.⁵ : **C23C 16/32, C23C 16/50**

(30) Priority : **21.02.90 JP 38330/90**

(43) Date of publication of application :
**25.09.91 Bulletin 91/39**

(84) Designated Contracting States :
**DE FR GB**

(71) Applicant : **NGK INSULATORS, LTD.**
**2-56, Suda-cho, Mizuho-ku**
**Nagoya City Aichi Pref. (JP)**

(72) Inventor : **Imanishi, Yuichiro**
**401 Hara 2-chome, Tenpaku-Ku**
**Nagoya City, Aichi Pref. (JP)**
Inventor : **Oshima, Masatsugu**
**38-2 Ichioka-Cho 2-chome, Mizuho-Ku**
**Nagoya City, Aichi Pref. (JP)**

(74) Representative : **Stoner, Gerard Patrick et al**
**Mewburn Ellis 2 Cursitor Street**
**London EC4A 1BQ (GB)**

(54) **Composite materials and a process for producing the same.**

(57) A composite material comprising a structural material and an amorphous SiC film covering a surface of the structural material. The ratio :C/(Si + C) between C and Si is not less than 0.03 and not more than 1 in terms of the number of atoms. A process for producing the composite material is also disclosed, which comprises the step of forming an amorphous SiC film onto a surface of a structural material by a plasma CVD, the film satisfying the above ratio. The process can be carried out at relatively low temperatures, and hence on a variety of structural materials.

$FIG\_1$

EP 0 448 227 A1

## COMPOSITE MATERIALS AND A PROCESS FOR PRODUCING THE SAME

The present invention relates to composite materials in which an SiC film is formed on the surface of a structural material, and also to processes for producing the same. In particular, the invention relates to composite materials capable of suitably using low melting point structural materials and a process for producing the same.

In order to impart properties, such as corrosion resistance, upon structural materials, a technique is formerly known, in which the surface of a structural material made of, for example, stainless steel, is covered with a crystalline SiC film having a ratio of Si:C being 1:1 in terms of number of atoms by a heat CVD.

In this heat CVD process, the structural material is coated with a desired crystalline SiC film formed by the by flowing $SiC\ell_4$ or $SiHC\ell_3$ as an Si source material and a C source material as a starting material along the structural material at a temperature not lower than 1,100°C under atmospheric pressure (See J. Schlichting, Powder Metallurgy International, 12(3), pp. 141 (1980), and T. Hirai, et al, Yogyo-Kyokai-Shi, 91(11), pp. 502 (1983)).

Owing to this, since the structural material to be covered with the crystalline SiC film needs to withstand a temperature not less than 1,100°C, there is a problem in that this technique cannot be applied to low melting point materials such as aluminum or stainless steel. That is, when a crystalline SiC film is to be formed on such a low melting point material by the heat CVD process, the structural material melts before the formation of the film.

It has been reported that an amorphous SiC film formed by plasma CVD is corroded by $C\ell F_3$ (See Sales Brochure "Proposal for self cleaning technology with $C\ell F_3$" Iwatani Sangyo K.K. & Central Glass K.K.). Thus, it has been predicted that the plasma CVD is no use for making SiC film coating.

The problem addressed herein is to provide new SiC coated products and coating processes, preferably non-corrodable products and preferably products and processes in which a low melting point material may be used.

A first aspect of the present invention is to provide composite materials in which the surface of a structural material is covered with an amorphous SiC film having a ratio:C/(Si + C) between C and Si being not less than 0.03 in terms of the number of atoms.

A second aspect of the present invention is to provide a process for producing a composite material by forming an amorphous SiC film onto the surface of a structural material by a plasma CVD process, the ratio:C/(Si + C) between C and Si being not less than 0.03 in terms of the number of atoms. The upper limit of C/(Si + C) is 1.

In the above-mentioned construction, since an amorphous SiC film having the specific ratio between C and Si in terms of the number of atoms can be formed on the surface of the structural material at low temperatures by the plasma CVD process, structural materials having low melting points can be used as the structural material.

The reason why the film is limited to the amorphous SiC film, in the present invention, is that unless the film is at least amorphous, the SiC film cannot be formed at low temperatures. In addition, if the ratio:C/(Si + C) between C and Si is less than 0.03 in terms of the number of atoms, as is clear from examples mentioned later, it deteriorates corrosion resistance. Therefore, the ratio is required to be not less than 0.03. Preferably it is at least 0.3.

Further, the reason why the plasma CVD process needs to be used for the formation of the amorphous SiC film is that the starting gaseous materials can be decomposed at low temperatures with the plasma generated, so that the amorphous SiC film may be formed at low temperatures, below 1100°C e.g. below 500°C.

It is preferable that the structural material is attached to the cathode side or the structural material itself is employed as the electrode or the cathode in the plasma CVD. For, in this case, plasma atoms impinge upon the cathode, so that the film can be firmly fixed to the surface of the structural material.

Further, in order to vary the ratio of C/(Si + C) between Si and C in terms of the number of atoms, the kinds and the flow rates of the SiC source material and the C source material as the starting material need to be varied.

In the SiC film, hydrogen, halogen, etc. are contained as inevitable impurities.

We have found that in this way, even though a CVD process capable of forming the film on the substrate having a low melting point at low temperatures is used, films having excellent corrosion resistance may be obtained.

Preferred features and advantages of the invention will be appreciated upon reading of the following description of embodiments when taken in conjunction with the attached drawings, with the understanding that these are given only as examples and modifications, variations and changes of the same could be made by the skilled person in the art to which the invention pertains.

For a better understanding of the invention, reference is made to the attached drawings, wherein:

Fig. 1 is a concept view for illustrating an example of the process for producing the composite material according to the present invention;

Fig. 2 is a concept view for illustrating another example of the process for producing the composite material according to the present invention; and

Figs. 3a and 3b are views illustrating a chemical reactor vessel and a pipe line, respectively.

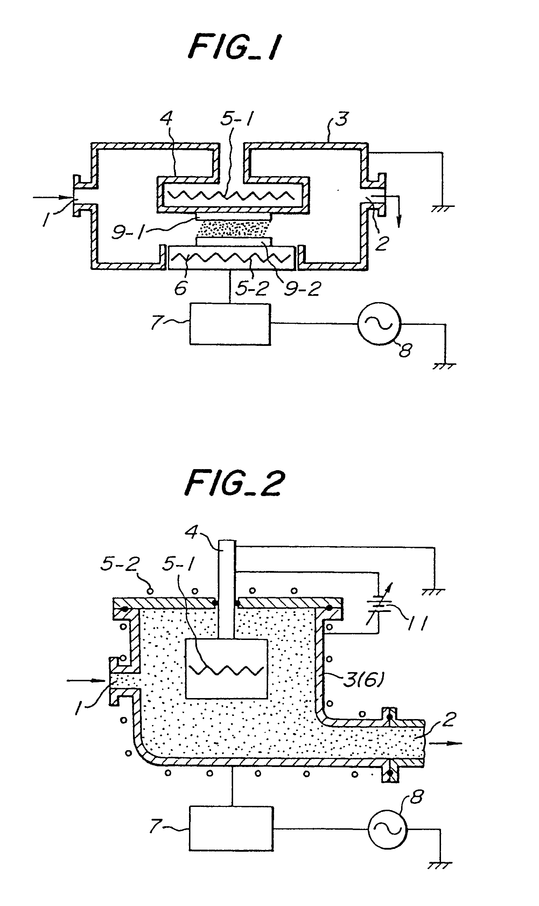

Fig. 1 is the concept view for illustrating an example of the producing process embodying the present invention. In the example of Fig. 1, a vessel provided with a gas introduction inlet 1 and a gas discharge outlet 2 is used for a plasma CVD apparatus. In this example of Fig. 1, an anode 4 and a heater 5-1 are provided in an upper portion of the vessel, and a cathode 6 and a heater 5-2 are provided in a lower portion. A high frequency power source 8 is provided between the anode 4 and the cathode 6 through a matching box 7.

An amorphous SiC film is formed by the plasma CVD apparatus shown in Fig. 1 as follows:

First, samples 9-1, 9-2 upon which the SiC film is to be vapor deposited are placed on the anode 4 and the cathode 6, respectively. Then, radio frequency power of, for example, 10 W, is applied between the anode 4 and the cathode 6 by the high frequency power source 8, and the cathode and the anode are heated to 500°C by the heaters 5-1 and 5-2. In this state, a starting material composed of an Si source material such as a hydride, for example, $SiH_4$, and a C source material such as $CH_4$ is fed through the gas introduction inlet 1, and the atmospheric gas inside the vessel 3 is sucked through the gas discharge outlet 2. By so doing, the plasma atoms are transmitted from the anode 4 to the cathode 6, the gaseous starting material is decomposed and vapor deposited onto the samples 9-1 and 9-2 to form the amorphous SiC film on each of the samples 9-1 and 9-2.

Fig. 2 is the concept view for illustrating another producing process to which the present techniques are applied. In the Example of Fig. 2, an amorphous SiC film is formed on the entire inner surface of a vessel 3. In Fig. 2, same reference numerals are given to the same or similar parts as those in Fig. 1, and explanation thereon is omitted. The example in Fig. 2 differs from that in Fig. 1 in that a DC power source 11 is connected such that the entire vessel 3 to be coated may be served as a cathode 6. Thereby, the plasma is generated toward the entire inner surface of the vessel 3 from the anode 4, so that the entire inner surface of the vessel 3 may be covered with the amorphous SiC film.

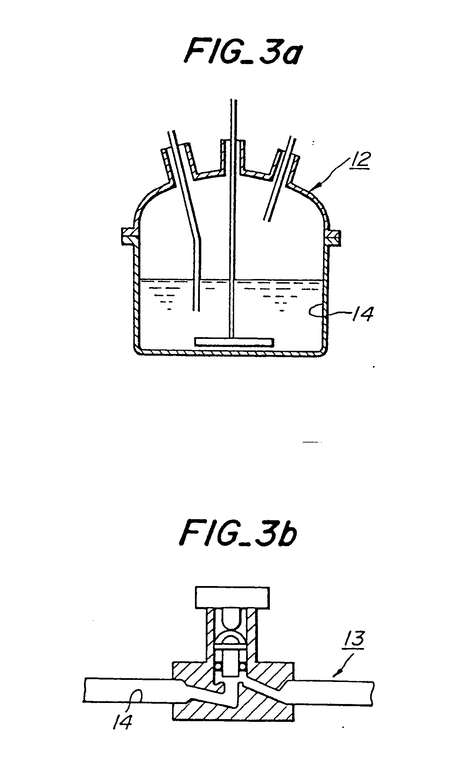

Figs. 3a and 3b illustrate a chemical reactor vessel 12 and a pipe line 13 each composed of a composite material embodying the present invention. In each of the reactor vessel 12 and the pipe line 13, the inner surface is provided with the amorphous SiC film layer 14. Therefore, the reactor vessel 12 and the pipe line 13 possess excellent corrosion resistance. Each of these reactor vessel 12 and the pipe line 13 is produced by using a producing process similar to that in Fig. 2.

In the following, film-forming conditions are summarized in Table 1.

Table 1

| Gaseous raw material | Si source | Hydride (SiH$_4$, etc.);  halide (SiF$_4$, SiHC$\ell_3$, etc.); organic material (SiH(CH$_3$)$_3$, etc.) |
|---|---|---|
| | C source | Hydride (CH$_4$, C$_2$H$_4$, etc.);  halide (CHC$\ell_3$, etc.) |
| | Other | N$_2$, Ar, H$_2$ as diluting gas |
| Substrate temperature | | room temperature ~ 500°C |
| Power | | 1 W ~ 1 KW |
| Gas pressure | | 10 mTorr ~ 20 Torr |
| Film thickness | | 100 Å to 30 $\mu$m |
| Gas flow rate | | SiH$_4$:0.1 ~ 200 sccm;   CH$_4$:0.1 ~ 500 sccm |

EP 0 448 227 A1

The ratio between Si atoms and C atoms in the amorphous SiC film can be changed by varying the kinds and the flow rates of the raw gaseous materials in Table 1.

Examples of the present invention will be explained below together with Comparative Examples.

Examples

In order to examine the corrosion resistance of composite materials, $SiH_4$ and $CH_4$ were used as gaseous starting materials in respective amounts in Table 3. The temperatures of substrates on the anode and cathode sides were set at 300°C and room temperature, respectively, and 4,000 Å thick amorphous SiC films having different ratios of C/(Si + C) in terms of the number of atoms were formed on aluminum substrates by the apparatus shown in Fig. 1 through application of RF power of 100-300 W under a gas pressure of 10 mTorr - 3 Torr while the flow rates of $SiH_4$ and $CH_4$ were varied. Thereby, composite materials according to the present invention and Comparative Example were obtained.

The producing conditions were as follows:

Kind of gas

| | |
|---|---|
| Si source | : $SiH_4$ |
| C source | : $CH_4$ |
| Diluting gas | : Ar, $H_2$ |
| Substrate temperature | : room temperature, to 400°C |
| Power | : 1 W to 300 W |
| Gas pressure | : 10 m Torr - 3 Torr |
| Film thickness | : 100 Å - 30 μm |
| Gas flow rate | : $SiH_4$ 0.1 - 100 sccm, |
| | $CH_4$ 0.1 - 400 sccm |

Each of the thus obtained composite materials embodying the present invention, and of the Comparative Examples, was subjected to a $C\ell F_3$ exposure test serving as a criterion for judging corrosion resistance by placing the sample in a vacuum vessel and filling the vessel with a $C\ell F_3$ gas diluted to 5% with nitrogen up to 1 atm at room temperature after the vessel was evacuated to vacuum. The vacuum vessel had such a volume as to maintain the concentration of the $C\ell F_3$ gas at 3% or more even if the film of the sample were all reacted and diminished. Then, a water contact angle, change in color (visual observation) after the exposure test, and positional changes in ESCA peaks of $C_{1s}$ and $Si_{2P}$ were determined between before and after the exposure judgment.

The contact angle was measured by a photograph, and water-repellent property was evaluated.

The surfaces of the composite materials were analyzed by ESCA as follows:

That is, the surface of each of the samples (not having undergone the above exposure test) was etched with Ar ions, and a time period up to a point of time when intensity of signals came to cause no change after the starting of the etching was determined. The measurement values were obtained with respect to the exposed samples after they were etched for the above time period. The locations of peaks in the ESCA reflect the chemically bound state of noted atoms, and have chemical shifts shown in Table 2.

Table 2

| Kind of bond | Chemical shift (eV) | |
|---|---|---|
| C (graphite) | $C_{1s}$ | 284.2 |
| SiC | $C_{1s}$ | 283.3 |
| CF | $C_{1s}$ | 287.8~288.4 |
| $CF_2$ | $C_{1s}$ | 292.5 |
| Si | $Si_{2P}$ | 99.1 |
| $SiO_2$ | $Si_{2P}$ | 103.6 |
| SiC | $Si_{2P}$ | 100.4 |

From the results, it is determined which was greatest, C-C, C-Si, or S-Si regarding bonds between Si and C before the exposure, and it is also determined which was greater, C-F or Si-F bonds after the exposure. The smaller the difference in shift amount between before and after the exposure, the better the corrosion resistance.

The ratio of C/(Si + C) was determined by an interpolation method with use of a FZ-Si single crystal as a standard sample. Results are shown in Table 3.

Table 3(a)

| Sample | | Gas composition (sccm) | | C/(Si+C) (%) in terms of number of atoms | Contact angle (°) | Change in color of film after exposure test (visual development) | Location of peak in ESCA | | | | | | Temper-ature of substrate (°C) | Gas pressure (m Torr) | Power (W) | Film thick-ness (Å) |
| | | | | | | | $C_{1s}$ (eV) | | | $Si_{2P}$(eV) | | | | | | |
| | | SiH$_4$ | CH$_4$ | | | | before expo-sure | after expo-sure | differ-ence | before expo-sure | after expo-sure | differ-ence | | | | |
| Example | 1 | 3.5 | 1.5 | 3.0 | 100 | changed | 282.9 | 284.9 | +2.0 | 99.1 | 103.0 | +3.9 | 300 | 100 | 10 | 4000 |
| | 2C* | 3.5 | 1.5 | 5.5 | 105 | changed | 282.8 | 285.0 | +2.2 | 99.1 | 103.0 | +3.9 | 28 | 100 | 10 | 4000 |
| | 3 | 2.5 | 2.5 | 6.5 | 110 | changed | 282.9 | 285.7 | +2.8 | 99.2 | 103.1 | +3.9 | 300 | 100 | 10 | 4000 |
| | 4C | 2.5 | 2.5 | 9.5 | 115 | changed | 283.0 | 285.5 | +2.5 | 99.4 | 103.0 | +3.6 | 28 | 100 | 10 | 4000 |
| | 5 | 1.5 | 3.5 | 14.5 | 120 | changed | 282.7 | 285.3 | +2.6 | 99.3 | 103.1 | +3.8 | 300 | 100 | 10 | 4000 |
| | 6C | 1.5 | 3.5 | 17.0 | 125 | changed | 283.1 | 283.6 | +0.5 | 99.8 | 100.2 | +0.4 | 28 | 100 | 10 | 4000 |
| | 7 | 1.0 | 4.0 | 24.0 | 130 | changed | 283.0 | 283.0 | ±0.0 | 99.9 | 99.8 | -0.1 | 300 | 100 | 10 | 4000 |
| | 8C | 1.0 | 4.0 | 27.5 | 130 | changed | 283.4 | 283.4 | ±0.0 | 100.3 | 100.1 | -0.2 | 28 | 100 | 10 | 4000 |
| | 9 | 0.7 | 4.3 | 31.0 | 135 | not changed | 283.3 | 283.4 | +0.1 | 100.0 | 100.1 | +0.1 | 300 | 100 | 10 | 4000 |
| | 10C | 0.7 | 4.3 | 40.0 | 145 | not changed | 283.7 | 283.6 | -0.1 | 100.1 | 100.2 | +0.1 | 28 | 100 | 10 | 4000 |
| | 11 | 1.0 | 4.0 | 27.0 | 120 | not changed | 282.9 | 283.0 | +0.1 | 99.7 | 99.8 | +0.1 | 300 | 100 | 10 | 4000 |
| | 12C | 1.0 | 4.0 | 29.0 | 135 | not changed | 283.2 | 283.3 | +0.1 | 99.9 | 100.1 | +0.2 | 28 | 100 | 10 | 4000 |
| | 13 | 0.2 | 4.8 | 50.0 | 150 | not changed | 283.8 | 283.8 | ±0.0 | 100.0 | 100.1 | +0.1 | 300 | 100 | 10 | 4000 |

Table 3(b)

| Sample | | Gas composition (sccm) | | C/(Si+C) (%) in terms of number of atoms | Contact angle (°) | Change in color of film after exposure test (visual develop-ment) | Location of peak in ESCA | | | | | | Temper-ature of substrate (°C) | Gas pressure (m Torr) | Power (W) | Film thick-ness (Å) |
| --- | --- | --- | --- | --- | --- | --- | --- | --- | --- | --- | --- | --- | --- | --- | --- | --- |
| | | | | | | | $C_{1s}$(eV) | | | $Si_{2P}$(eV) | | | | | | |
| | | SiH₄ | CH₄ | | | | before expo-sure | after expo-sure | differ-ence | before expo-sure | after expo-sure | differ-ence | | | | |
| Example | 14C | 0.2 | 4.8 | 65.5 | 155 | not changed | 284.0 | 284.0 | ±0.0 | 100.0 | 100.1 | +0.1 | 28 | 100 | 10 | 4000 |
| | 15 | 0 | 20 | 100 | 170 | not changed | 284.1 | 284.1 | ±0.0 | – | – | – | 28 | 100 | 300 | 3000 |
| | 16C | 0.7 | 4.3 | 40.0 | 145 | not changed | 283.7 | 283.7 | ±0.0 | 100.1 | 100.2 | +0.1 | 28 | 10 | 10 | 5000 |
| | 17 | 100 | 400 | 11.0 | 115 | changed | 283.0 | 285.3 | +2.3 | 99.5 | 102.3 | +2.8 | 400 | $3\times10^3$ | 5 | 5000 |
| | 18C | 2.5 | 2.5 | 16.5 | 125 | changed | 283.1 | 283.5 | +0.4 | 99.7 | 100.2 | +0.5 | 28 | 25 | 300 | 4000 |
| | 19 | 3.5 | 1.5 | 3.0 | 100 | changed | 282.9 | 285.0 | +2.1 | 99.1 | 103.0 | +3.9 | 300 | 100 | 10 | $3\times10^5$ |
| | 20C | 3.5 | 1.5 | 4.5 | 110 | changed | 282.8 | 285.0 | +2.2 | 99.1 | 103.0 | +3.9 | 28 | 100 | 1 | 1000 |
| Compar-ative Example | 1 | 4.8 | 0.2 | 1.0 | 45 | changed | 283.1 | 287.9 | +4.8 | 99.0 | 104.5 | +5.5 | 300 | 100 | 10 | 4000 |
| | 2 | 170 | 70 | 50 | 170 | not changed | 283.3 | 283.3 | ±0.0 | 100.4 | 100.4 | ±0.0 | 1600 (heat CVD) | $7.6\times10^5$ | – | 10000 |
| | 3 | 3.5 | 1.5 | 2.0 | 60 | changed | 283.0 | 287.8 | +4.8 | 99.0 | 104.7 | +5.7 | 300 | 100 | 0.8 | 3000 |
| | 4C | 1.0 | 4.0 | 30.5 | 115 | changed | 283.4 | 285.6 | +2.2 | 100.3 | 102.7 | +2.4 | 28 | $3\times10^4$ | 5 | 4000 |
| | 5 | 3.5 | 1.5 | 2.0 | 120 | changed | 283.0 | 285.6 | +2.6 | 99.3 | 103.1 | +3.8 | 300 | 100 | 1200 | 3000 |

Note: 1. "*" means that Sample was placed on the side of cathode.

2. Excluding Examples 15 and 20C and Comparative Example 3, the raw material diluted by ten fold with H₂ was used. In Example 15, CH₄ gas diluted by two fold with Ar was used.

3. In Comparative Example 2, carbon was used as a substrate, and $SiCl_4$ and $C_3H_8$ were used at flow rates of 170 and 70 sccm, instead of $SiH_4$ and $CH_4$, respectively.

EP 0 448 227 A1

From Table 3, it is seen that the samples having the value of C/(Si + C) not less than 0.03 had the smaller difference in the ESCA peak positions, better corrosion resistance, greater contact angle, and better water-repellent property as compared with those having the value of C/(Si + C) less than 0.03.

Further, it is seen that when the value is not less than 0.3, the color of the film did not change, and more excellent properties were obtained.

As clear from the above-mentioned explanation, according to the composite material and the producing process in embodiments of the present invention, since the amorphous SiC film having the given ratio between C and Si in terms of the the number of atoms is formed on the surface of the structural material by the plasma CVD process, the SiC film can be formed on the surface of the substrate at low temperatures. Thus, the composite material using the low melting point material can be obtained.

## Claims

1. A composite material comprising a structural material, and an amorphous SiC film covering a surface of the structural material, a ratio:C/(Si + C) between C and Si being not less than 0.03 and not more than 1 in terms of the number of atoms.

2. A composite material according to Claim 1, wherein the ratio of C/(Si + C) is not less than 0.3 in terms of the number of atoms.

3. A process for producing a composite material, comprising forming an amorphous SiC film onto a surface of a structural material by a plasma CVD, said amorphous SiC film having a ratio C/(Si + C) between C and Si not less than 0.3 in terms of the number of atoms.

4. A process according to Claim 3, wherein the plasma CVD is effected in the state that the structural material is fitted onto a side of a cathode.

5. A process according to Claim 3, wherein the plasma CVD is effected in the state that the structural material is used as an electrode.

6. A process according to any one of claims 3 to 5 in which the structural material is at a temperature below 400°C durng the CVD.

FIG_1

FIG_2

# FIG_3a

# FIG_3b

**European Patent Office**

## EUROPEAN SEARCH REPORT

Application Number

EP 91 30 1327

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 532 150 (M. ENDO et al.) * Column 5, lines 25-45; claim 1; table 1; figure 2 * | 1-3,5-6 | C 23 C 16/32 C 23 C 16/50 |
| Y |  | 4 | |
| | --- | | |
| Y | THIN SOLID FILMS, vol. 109, no. 2, November 1983, pages 145-158, Elsevier Sequoia, Lausanne, CH; Y. CATHERINE et al.: "Ion bombardment effects in plasma deposition of hydrogenated amorphous silicon carbide films: A comparitive study of D.C. and R.F. discharges" * Page 146, lines 8-28; table 1; figure 1 * | 4 | |

TECHNICAL FIELDS SEARCHED (Int. Cl.5)

C 23 C

The present search report has been drawn up for all claims

| Place of search | Date of completion of the search | Examiner |
|---|---|---|
| THE HAGUE | 16-05-1991 | EKHULT H.U. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)